Europäisches Patentamt

European Patent Office

Office européen des brevets

(19)

(11) **EP 1 217 723 A2**

(12) # EUROPEAN PATENT APPLICATION

(43) Date of publication:
**26.06.2002 Bulletin 2002/26**

(51) Int Cl.⁷: **H03C 3/40**, H03C 3/09

(21) Application number: **01114708.9**

(22) Date of filing: **21.06.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **30.11.2000 JP 2000364504**

(71) Applicant: **KABUSHIKI KAISHA TOSHIBA**
**Kawasaki-shi, Kanagawa-ken 210-8572 (JP)**

(72) Inventor: **Shibata, Shigeru,**
**Intellectual Property Division**
**Minato-ku Tokyo 105-8001 (JP)**

(74) Representative: **HOFFMANN - EITLE**
**Patent- und Rechtsanwälte**
**Arabellastrasse 4**
**81925 München (DE)**

(54) **Quadrature modulator using a Phase Locked Loop**

(57) The fundamental waves and 3rd harmonics waves of two local signals output from a 90° phase shifter (2) are suppressed by use of low-pass filters (3a, 3b). The local signals in which the fundamental waves and 3rd harmonics waves are suppressed are respectively supplied to two multipliers (4a, 4b) and respectively multiplied by Ich and Qch base band signals. The results of multiplication in the two multipliers (4a, 4b) are added together in an adder (5) to create a modulation signal.

FIG.3

**Description**

This invention relates to a quadrature modulation apparatus for performing quadrature modulation for two-channel base-band signals, a radio transmission apparatus using the quadrature modulation apparatus and a quadrature modulation method.

A quadrature modulation apparatus respectively multiplies Ich and Qch base-band modulation signals by two local signals. The two local signals each have a fundamental wave of a predetermined frequency fif and the phase difference therebetween is 90°. A modulation signal is derived by adding together the results of multiplication of the Ich and Qch signals.

For example, the thus derived modulation signal is amplified by a non-linear amplifier and used for radio transmission. However, a modulation signal output from the quadrature modulation apparatus contains harmonic components. Therefore, if the modulation signal is amplified as it is by the non-linear amplifier, various intermodulation components appear in the modulation signal obtained after amplification. Since the frequency separation amount of a 3rd intermodulation component among the above intermodulation components with respect to the fundamental wave is small, it is difficult to suppress the same even if a filter is provided in the succeeding stage of the non-linear amplifier and the 3rd intermodulation component is output to the exterior as it is and processed as a spurious wave. Such a spurious wave causes a problem that power of the output signal leaking to the adjacent channel increases, lowering the modulation accuracy of the output signal.

If the frequency of the fundamental wave of the modulation signal is $(fif+f_{BB})$, the frequency of a 3rd harmonics of modulation signal becomes $(3fif-f_{BB})$. In this specification, the 3rd harmonics of modulation signal is hereinafter referred to as a 3rd wave.

An output signal of the non-linear amplifier obtained when the fundamental wave $(fif+f_{BB})$ and 3rd wave $(3fif-f_{BB})$ are input to the non-linear amplifier is explained in detail below.

If the frequencies of two input signals are set at f1, f2, a 3rd intermodulation component caused in the output signal of the non-linear amplifier can be expressed as follows.

$$(-2)\times f1+(+1)\times f2$$

Assuming that $f1=fif+f_{BB}$ and $f2=3fif-f_{BB}$, the following equation can be attained and a signal $(fif-3f_{BB})$ is derived as the 3rd intermodulation component.

$$(-2)\times f1+(+1)\times f2 = (-2)\times(fif+f_{BB})+(+1)\times(3fif-f_{BB}) = fif-3f_{BB}$$

Since the coefficient of the term $(3fif-f_{BB})$ in the equation for deriving the intermodulation component is $(+1)$, the 3rd intermodulation component increases by A [dB] if the 3rd wave $(3fif-f_{BB})$ in the input signal to the non-linear amplifier increases by A [dB]. That is, the 3rd intermodulation component increases in the ratio of 1:1 with respect to the 3rd wave. Therefore, the 3rd intermodulation component can be reduced by suppressing the level of the 3rd wave in the modulation signal.

In the conventional quadrature modulation apparatus, an attempt is made to provide a low-pass filter and output a modulation signal after suppressing the level of the 3rd wave by use of the low-pass filter.

In this case, since the level of the 3rd wave of the input of the non-linear amplifier and the level of the 3rd intermodulation component of the output from the non-linear amplifier correspond to each other in the ratio of 1:1 as described before, the relation between the suppression ratio of the 3rd wave in the low-pass filer and the suppression ratio of the 3rd intermodulation component (spurious wave) in the output from the non-linear amplifier is also set at 1:1.

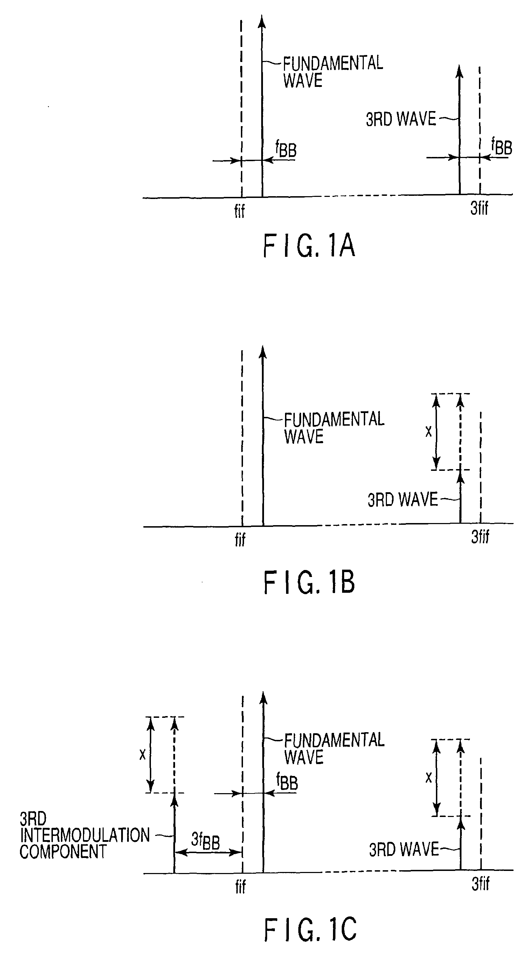

From the above fact, the 3rd intermodulation component of a modulation signal after being amplified by the non-linear amplifier can be suppressed by X [dB] as shown in FIG. 1C by suppressing the 3rd wave of the modulation signal having a spectrum as shown in FIG. 1A by X [dB] as shown in FIG. 1B by use of a low-pass filter.

Therefore, the 3rd intermodulation component can be suppressed to a lower level as a low-pass filter having a larger suppression ratio with respect to the frequency of the 3rd wave is used. However, in this case, since the signal level is lowered if the fundamental wave is also suppressed, it is required for the low-pass filter to have a characteristic which permits the frequency component of the fundamental wave to sufficiently pass therethrough.

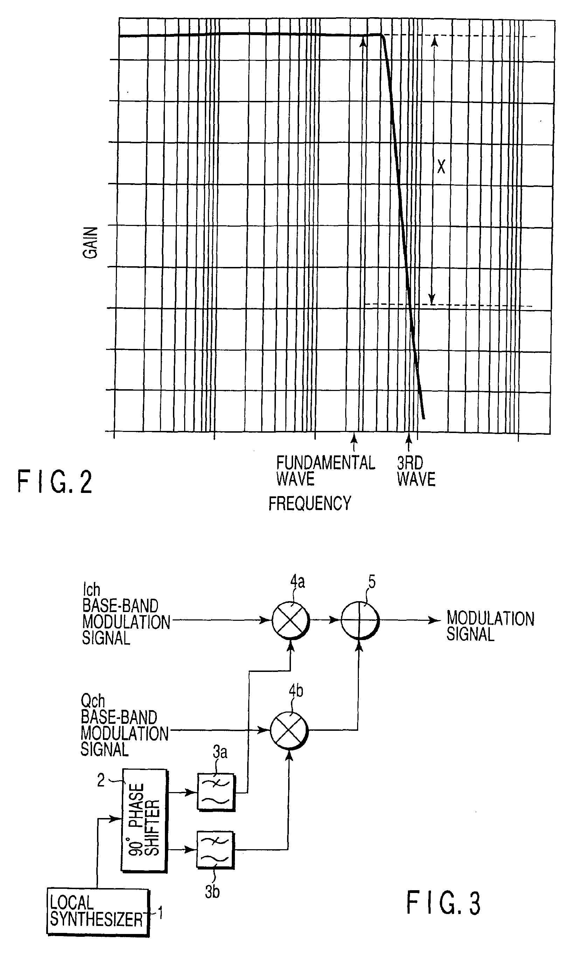

As a result, the low-pass filter in which the suppression ratio X [dB] for the 3rd wave is set sufficiently large is required to have a steeply changing frequency-gain characteristic as shown in FIG. 2.

However, the low-pass filter having such a steeply changing frequency-gain characteristic as shown in FIG. 2 becomes complicated in construction. Consequently, there occurs a problem that the size increases, the weight increases and the cost rises.

An object of this invention is to efficiently reduce harmonic waves of a modulation signal by use of a low-pass filter which has a relatively small suppression ratio for the harmonic waves and a smoothly changing frequency-gain characteristic and is simple in construction.

The above object can be attained by a quadrature modulation apparatus comprising local signal generator which generates two local signals each having a fundamental wave of a predetermined frequency and having a 90° phase difference therebetween, two low-pass filters which suppresses high-frequency band components of the two local signals generated from the local signal generator, each of the high-frequency band components containing the fundamental wave, and modulator which inputs the two local signals respectively outputs from the two low-pass filters and which outputs two-channel quadrature modulated base-band signals.

Further, the above object can be attained by a radio transmission apparatus comprising local signal generator which generates two local signals each having a fundamental wave of a predetermined frequency and having a 90° phase difference therebetween, two low-pass filters which suppresses high-frequency band components of the two local signals generated from the local signal generator, each of the high-frequency band components containing the fundamental wave, modulator which inputs the two local signals respectively outputs from the two low-pass filters which outputs two-channel quadrature modulated base-band signals, and transmitter which transmits the modulated signal.

In addition, the above object can be attained by a quadrature modulation method comprising the steps of generating two local signals each having a fundamental wave of a predetermined frequency and having a 90° phase difference therebetween; suppressing high-frequency band components of the two local signals, each of the high-frequency band components containing the fundamental wave; and subjecting two-channel base-band signals to quadrature modulation by use of the two local signals whose high-frequency band components are suppressed.

This summary of the invention does not necessarily describe all necessary features so that the invention may also be a sub-combination of these described features.

The invention can be more fully understood from the following detailed description when taken in conjunction with the accompanying drawings, in which:

FIGS. 1A, 1B, 1C are spectrum diagrams showing the state of distribution of a fundamental wave, 3rd wave and 3rd intermodulation component;

FIG. 2 is a diagram showing the frequency-gain characteristic required for a low-pass filter provided for the conventional quadrature modulation apparatus;

FIG. 3 is a block diagram showing the construction of the main portion of a quadrature modulation apparatus according to a first embodiment of this invention;

FIG. 4 is a diagram showing the frequency-gain characteristic of low-pass filters 3a, 3b shown in FIG. 3;

FIG. 5 is a block diagram showing the construction of a first embodiment of a radio transmission apparatus constructed by using the quadrature modulation apparatus shown in FIG. 3;

FIGS. 6A, 6B, 6C, 6D are spectrum diagrams showing the state of distribution of a fundamental wave, 3rd wave and 3rd intermodulation component in respective portions of the radio transmission apparatus shown in FIG. 5;

FIG. 7 is a diagram showing the relation between the local signal input to the quadrature modulator 3 shown in FIG. 3 and the 3rd wave of the modulation signal output from the quadrature modulator 3;

FIG. 8 is a block diagram showing the construction of a second embodiment of a radio transmission apparatus constructed by using the quadrature modulation apparatus shown in FIG. 3;

FIG. 9 is a block diagram showing the construction of a third embodiment of a radio transmission apparatus constructed by using the quadrature modulation apparatus shown in FIG. 3;

FIG. 10 is a block diagram showing the construction of a fourth embodiment of a radio transmission apparatus constructed by using the quadrature modulation apparatus shown in FIG. 3;

FIG. 11 is a block diagram showing the construction of a fifth embodiment of a radio transmission apparatus constructed by using the quadrature modulation apparatus shown in FIG. 3;

FIG. 12 is a block diagram showing the construction of a sixth embodiment of a radio transmission apparatus constructed by using the quadrature modulation apparatus shown in FIG. 3;

FIG. 13 is a block diagram showing the construction of a seventh embodiment of a radio transmission apparatus constructed by using the quadrature modulation apparatus shown in FIG. 3;

FIG. 14 is a block diagram showing the construction of an eighth embodiment of a radio transmission apparatus constructed by using the quadrature modulation apparatus shown in FIG. 3; and

FIG. 15 is a block diagram showing the construction of a ninth embodiment of a radio transmission apparatus constructed by using the quadrature modulation apparatus shown in FIG. 3.

There will now be described embodiments of this invention with reference to the accompanying drawings.

FIG. 3 is a block diagram showing the construction of the main portion of a quadrature modulation apparatus according to a first embodiment of this invention.

As shown in FIG. 3, the quadrature modulation apparatus of this embodiment includes a local synthesizer 1, a 90° phase shifter 2 used as local signal generating means, low-pass filters 3a, 3b, multipliers 4a, 4b and an adder 5.

The local synthesizer 1 generates a local signal having a fundamental wave of a predetermined frequency fif and supplies the local signal to the 90° phase shifter 2.

The 90° phase shifter 2 divides the local signal into two local signals having a 90° phase difference therebetween. Then, the 90° phase shifter 2 supplies the two local signals to the respective low-pass filters 3a, 3b.

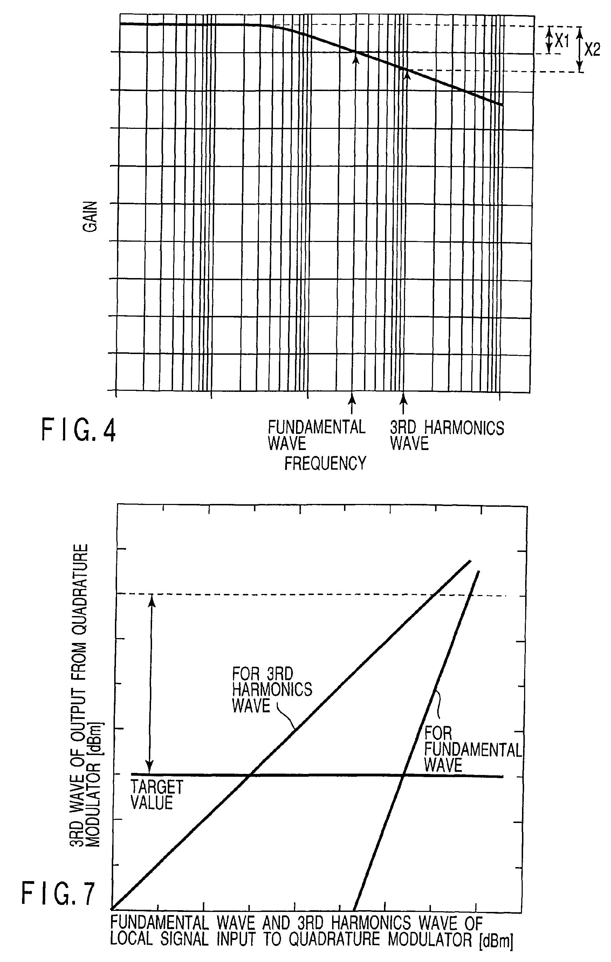

The low-pass filters 3a, 3b permit the local signals supplied from the 90° phase shifter 2 to pass therethrough without suppressing the low-frequency components of the local signals. The low-frequency components which are permitted to pass through the low-pass filters 3a, 3b without being suppressed do not contain the fundamental wave of the local signal. That is, each of the low-pass filters 3a, 3b has a frequency-gain characteristic as shown in FIG. 4, for example, and suppresses the fundamental wave and harmonic waves of the local signal. The low-pass filters 3a, 3b respectively supply local signals whose high-frequency components are suppressed to the two multipliers 4a, 4b.

Ich and Qch base-band modulation signals are respectively supplied to the multipliers 4a, 4b. The multipliers 4a, 4b multiply the base-band modulation signals by the local signals respectively supplied thereto. The multipliers 4a, 4b supply the results of multiplication to the adder 5.

The adder 5 adds together the outputs of the multipliers 4a, 4b and outputs the result of addition as a modulation signal used as the result of quadrature modulation.

Thus, the Ich and Qch base-band modulation signals are subjected to the quadrature modulation by use of the multipliers 4a, 4b and adder 5 and modulation means is constructed by the multipliers 4a, 4b and adder 5.

The construction of the quadrature modulation apparatus of this embodiment has been explained and some embodiments of a radio transmission apparatus using the quadrature modulation apparatus are explained below.

(First Embodiment)

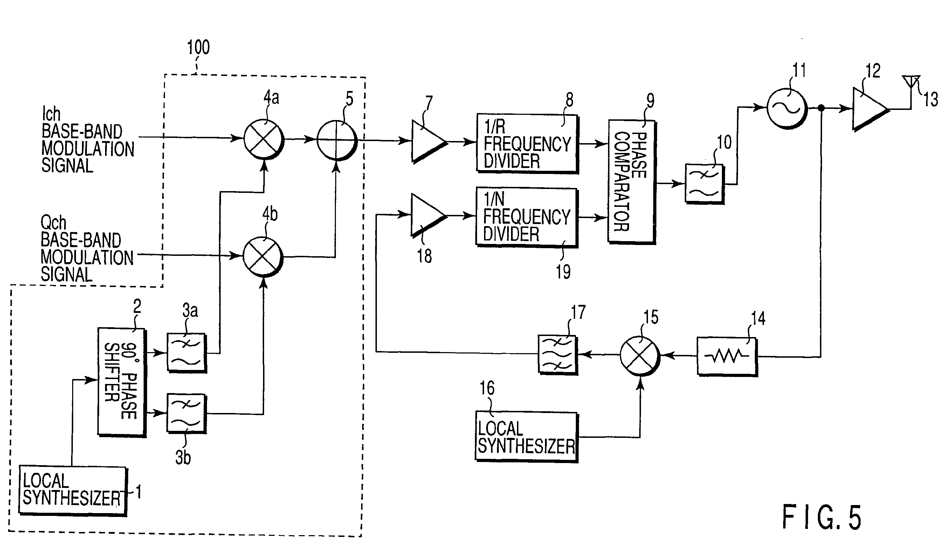

FIG. 5 is a block diagram showing the construction of the main portion of a radio transmission apparatus constructed by using the quadrature modulation apparatus 100 shown in FIG. 3. Portions which are the same as those shown in FIG. 3 are denoted by the same reference numerals and a detail explanation is therefore omitted.

As shown in FIG. 5, the radio transmission apparatus of this embodiment includes the quadrature modulation apparatus 100, non-linear amplifier 7, 1/R frequency divider 8, phase comparator 9, loop filter 10, voltage-controlled oscillator 11, main amplifier 12, antenna 13, attenuator 14, down-converting mixer 15, local synthesizer 16, band-pass filter 17, non-linear amplifier 18 and 1/N frequency divider 19.

The quadrature modulation apparatus 100 is the same as that shown in FIG. 3. A modulation signal output from the quadrature modulation apparatus 100 is supplied to the non-linear amplifier 7 which in turn amplifies the modulation signal so that the amplitude thereof can be set to an adequate amplitude level. Then, the modulation signal after being amplified by the non-linear amplifier 7 is frequency-divided by the 1/R frequency divider 8 so that the frequency of the modulation signal will be divided by R and then the modulation signal is supplied to the phase comparator 9.

A signal from the 1/N frequency divider 19 is also supplied to the phase comparator 9 in addition to the signal from the 1/R frequency divider 8. The phase comparator 9 compares the phases of the two input signals and outputs a control signal having a voltage level corresponding to the phase difference between the signals. Unwanted harmonic waves and noise of the control signal output from the phase comparator 9 are eliminated by the loop filter 10 and then the control signal is supplied to the voltage-controlled oscillator 11.

The voltage-controlled oscillator 11 oscillates at a frequency corresponding to the voltage level of the control signal supplied from the loop filter 10 and outputs a signal obtained by oscillation as a transmission signal. The voltage-controlled oscillator 11 generates a transmission signal having the central frequency belonging to a predetermined system communication frequency band. The transmission signal output from the voltage-controlled oscillator 11 is amplified by the main amplifier 12 to a power level required for radio transmission and then supplied to the antenna 13. The transmission signal is emitted from the antenna 13 into space as radio waves.

The transmission signal output from the voltage-controlled oscillator 11 is branched and input to the attenuator 14 and attenuated to an adequate amplitude level in the attenuator 14. Then, the transmission signal attenuated by the attenuator 14 is multiplied by a local signal generated by the local synthesizer 16 and thus down-converted in the down-converting mixer 15. Unwanted frequency components of the thus down-converted transmission signal are eliminated by the band-pass filter 17 and then the transmission signal is amplified by the non-linear amplifier 18 so that the amplitude thereof will be set to an adequate amplitude level. The modulation signal after being amplified by the non-linear amplifier 18 is frequency-divided by the 1/N frequency divider 19 so that the frequency thereof will be divided by N and then the modulation signal is supplied to the phase comparator 9.

The non-linear amplifier 7, 1/R frequency divider 8, phase comparator 9, loop filter 10, voltage-controlled oscillator 11, attenuator 14, down-converting mixer 15, local synthesizer 16, band-pass filter 17, non-linear amplifier 18 and 1/N frequency divider 19 are combined to construct a phase locked loop (PLL).

That is, the radio transmission apparatus radio-transmits the modulation signal obtained by the quadrature modulation apparatus 100 according to a modulation loop system by use of radio transmission means realized by the PLL and main amplifier 12.

Next, the operation of the radio transmission apparatus with the above construction is explained.

First, Ich and Qch base-band modulation signals output from a base-band section (not shown) are input to the quadrature modulation apparatus 100.

In the quadrature modulation apparatus 100, a local signal having the fundamental wave of a predetermined frequency fif is generated by the local synthesizer 1. The local signal is divided into two local signals having a 90° phase difference therebetween in the 90° phase shifter 2 and the two local signals are respectively supplied to the multipliers 4a, 4b via the low-pass filters 3a, 3b.

The Ich and Qch base-band modulation signals which are input to the quadrature modulation apparatus 100 are supplied to the multipliers 4a, 4b. Thus, the Ich base-band modulation signal is multiplied by the local signal supplied thereto via the low-pass filter 3a in the multiplier 4a and the Qch base-band modulation signal is multiplied by the local signal supplied thereto via the low-pass filter 3b in the multiplier 4b. Then, a modulation signal obtained by subjecting the Ich and Qch base-band modulation signals to the quadrature modulation can be derived by adding together the signals obtained by the multipliers 4a, 4b in the adder 5. The modulation signal obtained as an output of the adder 5 is supplied as it is to the non-linear amplifier 7 as an output of the quadrature modulation apparatus 100 without passing through a filter.

In a case where the PLL is set in the locked state, the oscillation frequency of the voltage-controlled oscillator 8 is so controlled that no phase difference will occur between the two signals input to the phase comparator 9. That is, the PLL causes the voltage-controlled oscillator 8 to oscillate so as to cancel phase deviation caused by a signal output from the quadrature modulation apparatus 100. As a result, the voltage-controlled oscillator 8 can generate a transmission signal having the same phase deviation as the modulation signal output from the quadrature modulation apparatus 100.

The transmission signal thus generated from the PLL is amplified by the main amplifier 12, supplied to the antenna 13 and transmitted by radio from the antenna 13.

Since the 1/R frequency divider 8 and phase comparator 9 are required to operate as complete logic circuits when the above modulation loop system is used, a signal input to the 1/R frequency divider 8 is required to have an amplitude which correctly operates the logic circuit. Therefore, it is required to wave-shape the modulation signal output from the quadrature modulator 3 into a signal having a necessary amplitude level and the non-linear amplifier 7 is provided for this purpose.

In the non-linear amplifier 7, a 3rd intermodulation component is generated by the non-linear operation thereof, but the 3rd intermodulation component can be suppressed by the action of the quadrature modulation apparatus 100 as explained below in this embodiment.

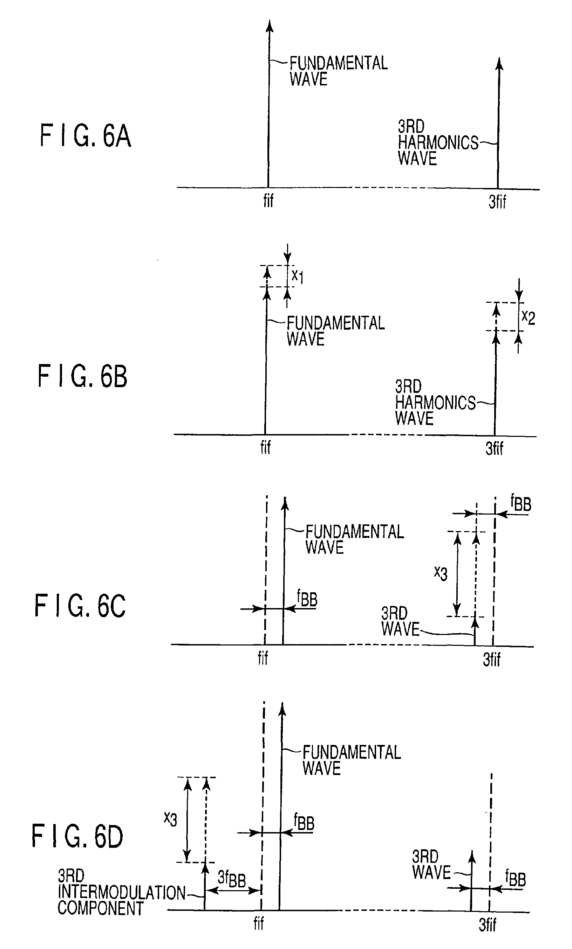

First, assume that the fundamental wave (frequency = fif) component and 3rd harmonics wave (frequency = 3fif) component of the local signal output from the 90° phase shifter 2 are set in the relation as shown in FIG. 6A. Since the low-pass filters 3a, 3b have the frequency-gain characteristic as shown in FIG. 4, the fundamental wave and 3rd harmonics wave of the local signal are respectively attenuated by $X_1$ [dB] and $X_2$ [dB] as shown in FIG. 6B after the local signal has passed through the low-pass filters 3a, 3b.

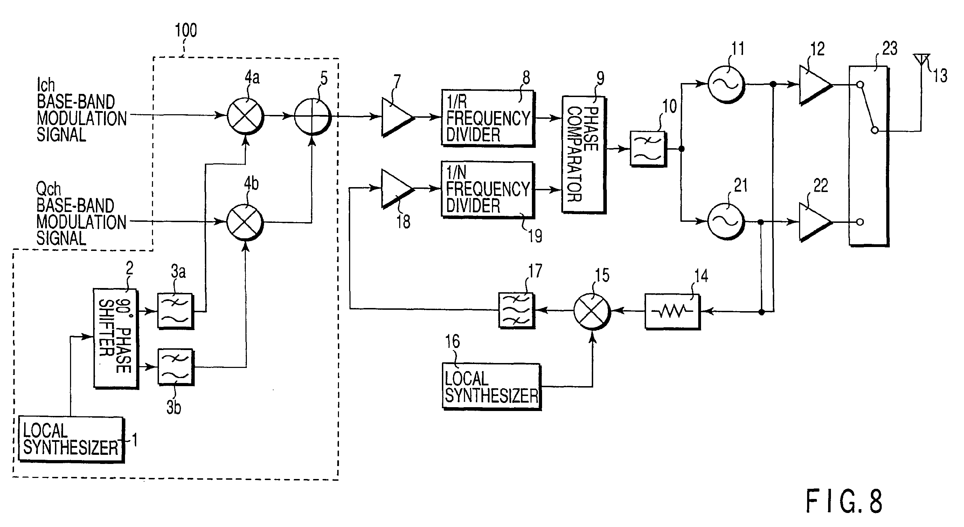

The local signal input to the multipliers 4a, 4b and the 3rd wave of the modulation signal output from the adder 5 are set in the relation as shown in FIG. 7. That is, the 3rd wave of the modulation signal output from the adder 5 is set in the relation of approx. 1:1 with respect to the 3rd harmonics wave of the local signal input to the multipliers 4a, 4b and is set in the relation of approx. 3:1 with respect to the fundamental wave of the local signal.

Therefore, since the quadrature modulation is performed by use of the local signal whose fundamental wave and 3rd harmonics wave are suppressed as described above, the 3rd wave (frequency = $fif-3f_{BB}$) of the modulation signal is suppressed at a rate $X_3$ [dB] approximately corresponding to $(3X_1+X_2)$ as shown in FIG. 6C in comparison with a case wherein the quadrature modulation is performed by using the local signal output from the 90° phase shifter 2 as it is.

Then, the 3rd intermodulation component (frequency = $fif-3f_{BB}$) caused by amplifying the modulation signal whose 3rd wave is thus sufficiently suppressed by use of the non-linear amplifier 7 is suppressed at the rate $X_3$ [dB] as shown in FIG. 6D in comparison with a case wherein the quadrature modulation is performed by using the local signal output from the 90° phase shifter 2 as it is.

Thus, even if the modulation signal is amplified by the non-linear amplifier 7, the 3rd intermodulation component caused by amplification is made sufficiently small, the 3rd wave is also sufficiently suppressed and a modulation signal containing a less spurious wave can be supplied to the 1/R frequency divider 8. As a result, spurious signals transmitted by radio from the antenna 13 can be reduced.

Further, in this embodiment, since the suppression ratios $X_1$ [dB], $X_2$ [dB] of the low-pass filters 3a, 3b can be made sufficiently low with respect to the suppression ratios $X_3$ [dB] of the 3rd intermodulation component and not only the 3rd wave but also the fundamental wave is suppressed, the frequency-gain characteristic of the low-pass filters 3a, 3b can be set to a smoothly changing characteristic as shown in FIG. 4. Therefore, the low-pass filters 3a, 3b can be realized with an extremely simple construction in comparison with the low-pass filter having the frequency-gain characteristic as shown in FIG. 2.

(Second Embodiment)

FIG. 8 is a block diagram showing the construction of a radio transmission apparatus constructed by using the quadrature modulation apparatus 100 shown in FIG. 3. Portions which are the same as those shown in FIGS. 3, 5 are denoted by the same reference numerals and a detailed explanation therefor is omitted.

As shown in FIG. 8, the radio transmission apparatus of this embodiment includes the quadrature modulation apparatus 100, non-linear amplifier 7, 1/R frequency divider 8, phase comparator 9, loop filter 10, voltage-controlled oscillator 11, main amplifier 12, antenna 13, attenuator 14, down-converting mixer 15, local synthesizer 16, band-pass filter 17, non-linear amplifier 18, 1/N frequency divider 19, voltage-controlled oscillator 21, main amplifier 22 and selector 23.

That is, the radio transmission apparatus of this embodiment includes the voltage-controlled oscillator 21, main amplifier 22 and selector 23 in addition to the radio transmission apparatus of the first embodiment.

A control signal output from the loop filter 10 is branched and input to the voltage-controlled oscillator 21. The voltage-controlled oscillator 21 oscillates at a frequency corresponding to the voltage level of the control signal supplied from the loop filter 10 and outputs a signal thus obtained as a transmission signal. The voltage-controlled oscillator 21 generates a transmission signal having the central frequency belonging to a predetermined system communication frequency band, but the system communication frequency band is different from the system communication frequency band to which the transmission signal output from the voltage-controlled oscillator 11 belongs.

The transmission signal output from the voltage-controlled oscillator 21 is amplified by the main amplifier 22 to a power level required for radio transmission. The transmission signals output from the voltage-controlled oscillators 11, 21 are both supplied to the selector 23. The selector 23 selects one of the transmission signals and supplies the selected transmission signal to the antenna 13. The transmission signal selected by the selector 23 is emitted from the antenna 13 into space as radio waves.

The transmission signal output from the voltage-controlled oscillator 21 is also branched and input to the attenuator 14.

Thus, a PLL is constructed by the non-linear amplifier 7, 1/R frequency divider 8, phase comparator 9, loop filter 10, voltage-controlled oscillator 21, attenuator 14, down-converting mixer 15, local synthesizer 16, band-pass filter 17, non-linear amplifier 18 and 1/N frequency divider 19 in addition to the PLL constructed by the non-linear amplifier 7, 1/R frequency divider 8, phase comparator 9, loop filter 10, voltage-controlled oscillator 11, attenuator 14, down-converting mixer 15, local synthesizer 16, band-pass filter 17, non-linear amplifier 18 and 1/N frequency divider 19. While one of the voltage-controlled oscillators 11, 21 is operated, the operation of the other voltage-controlled oscillator is interrupted. As a result, one of the two PLLs is made effective at a certain time point.

In each PLL, a transmission signal belonging to one of the system communication frequency bands which are different from each other is generated. The transmission signal is amplified by one of the main amplifiers 11 and 21, supplied to the antenna 13 via the selector 23 and transmitted by radio.

That is, like the radio transmission apparatus of the first embodiment, the radio transmission apparatus of this embodiment transmits the modulation signal obtained by the quadrature modulation apparatus 100 by radio by use of the modulation loop system, and either of the two different system communication frequency bands can be used.

Like the first embodiment, in the second embodiment, even if the modulation signal is amplified by the non-linear amplifier 7, the 3rd intermodulation component caused by amplification is made sufficiently small, the 3rd wave is also sufficiently suppressed and a modulation signal containing a less spurious wave can be supplied to the 1/R frequency divider 8. As a result, spurious signals transmitted by radio from the antenna 13 can be reduced.

Further, in this embodiment, since the suppression ratios $X_1$ [dB], $X_2$ [dB] of the low-pass filters 3a, 3b can be made sufficiently low with respect to the suppression ratios $X_3$ [dB] of the 3rd intermodulation component and not only the 3rd wave but also the fundamental wave is suppressed, the frequency-gain characteristic of the low-pass filters 3a, 3b can be set to a smoothly changing characteristic as shown in FIG. 4. Therefore, the low-pass filters 3a, 3b can be realized with an extremely simple construction in comparison with the low-pass filter having the frequency-gain characteristic as shown in FIG. 2.

(Third Embodiment)

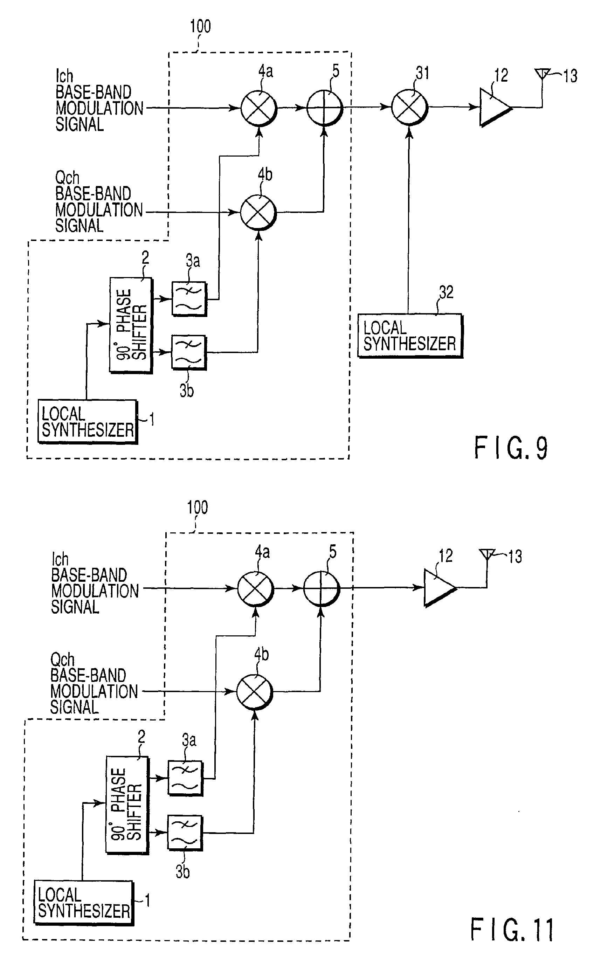

FIG. 9 is a block diagram showing the construction of a radio transmission apparatus constructed by using the quadrature modulation apparatus 100 shown in FIG. 3. Portions which are the same as those shown in FIG. 3 are denoted by the same reference numerals and a detailed explanation therefor is omitted.

As shown in FIG. 9, the radio transmission apparatus of this embodiment includes the quadrature modulation apparatus 100, main amplifier 12, antenna 13, up-converter 31 and local synthesizer 32.

A modulation signal output from the quadrature modulation apparatus 100 is supplied to the up-converter 31. The up-converter 31 is supplied with a local signal from the local synthesizer 32 in addition to the modulation signal supplied from the quadrature modulation apparatus 100. Then, the up-converter 31 generates a transmission signal obtained by multiplying the modulation signal by the local signal and up-converting the modulation signal to a frequency band corresponding to the frequency of the local signal. The local synthesizer 32 generates a local signal having the central frequency of a predetermined system communication frequency band. Therefore, the central frequency of transmission signal belongs to the predetermined system communication frequency band.

The transmission signal generated from the up-converter 31 is supplied to the main amplifier 12.

That is, the radio transmission apparatus transmits the modulation signal obtained by the quadrature modulation apparatus 100 by radio according to an up-conversion system by use of radio transmission means realized by the main amplifier 12, up-converter 31 and local synthesizer 32.

With the above construction, since the up-converter 31 performs the non-linear operation like the non-linear amplifier 7 in the first embodiment, a 3rd intermodulation component is contained in the transmission signal which is an output of the up-converter 31. However, the 3rd intermodulation component can be suppressed to a sufficiently small value by the same action as in the first embodiment, the 3rd wave is also sufficiently suppressed and a modulation signal containing a less spurious wave can be supplied to the 1/R frequency divider 8. As a result, spurious signals transmitted by radio from the antenna 13 can be reduced.

Further, in this embodiment, since the suppression ratios $X_1$ [dB], $X_2$ [dB] of the low-pass filters 3a, 3b can be made sufficiently low with respect to the suppression ratios $X_3$ [dB] of the 3rd intermodulation component and not only the 3rd wave but also the fundamental wave is suppressed, the frequency-gain characteristic of the low-pass filters 3a, 3b can be set to a smoothly changing characteristic as shown in FIG. 4. Therefore, the low-pass filters 3a, 3b can be realized with an extremely simple construction in comparison with the low-pass filter having the frequency-gain characteristic as shown in FIG. 2.

(Fourth Embodiment)

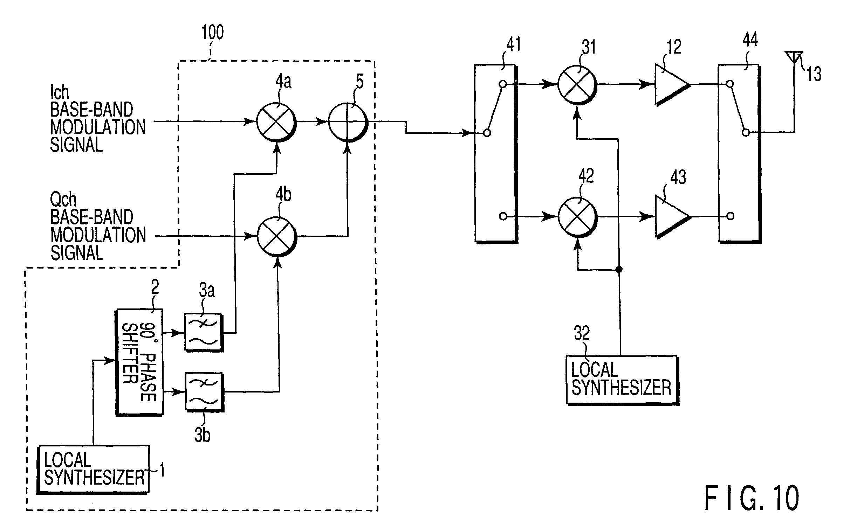

FIG. 10 is a block diagram showing the construction of a radio transmission apparatus constructed by using the quadrature modulation apparatus 100 shown in FIG. 3. Portions which are the same as those shown in FIGS. 3, 9 are denoted by the same reference numerals and a detailed explanation therefor is omitted.

As shown in FIG. 10, the radio transmission apparatus of this embodiment includes the quadrature modulation apparatus 100, main amplifier 12, antenna 13, up-converter 31, local synthesizer 32, selector 41, up-converter 42, main amplifier 43 and selector 44.

That is, the radio transmission apparatus of this embodiment includes the selector 41, up-converter 42, main amplifier 43 and selector 44 in addition to the radio transmission apparatus of the third embodiment.

A modulation signal output from the quadrature modulation apparatus 100 is supplied to the selector 41. The selector 41 selectively supplies the modulation signal output from the quadrature modulation apparatus 100 to one of the up-converters 31 and 42. The up-converter 42 is supplied with a local signal from the local synthesizer 32 in addition to the modulation signal supplied via the selector 41. Then, the up-converter 31 generates a transmission signal obtained by multiplying the modulation signal by the local signal and up-converting the modulation signal to a frequency band corresponding to the frequency of the local signal. The local synthesizer 32 generates a local signal having the central frequency of a predetermined system communication frequency band and it outputs a local signal of a frequency associated with one of the different system communication frequency bands according to one of the up-converters 31 and 42 selected by the selector 41.

The transmission signal output from the up-converter 42 is amplified by the main amplifier 43 to a power level required for radio transmission and supplied to the antenna 13 via the selector 44. The selector 44 selects one of the main amplifiers 12 and 43 in an interlocked manner with the selector 41. The selector 44 supplies the transmission signal output from the selected main amplifier to the antenna 13.

That is, the radio transmission apparatus transmits the modulation signal obtained by the quadrature modulation apparatus 100 by radio according to an up-conversion system and permits either of the two different system communication frequency bands to be used.

With the above construction, the up-converters 31, 42 perform the non-linear operation like the non-linear amplifier 7 in the first embodiment. Therefore, a 3rd intermodulation component is contained in the transmission signal which is an output of each of the up-converters 31, 42. However, the 3rd intermodulation component can be suppressed to a sufficiently small value by the same action as in the first embodiment, the 3rd wave is also sufficiently suppressed and a modulation signal containing a less spurious wave can be supplied to the 1/R frequency divider 8. As a result, spurious signals transmitted by radio from the antenna 13 can be reduced.

Further, in this embodiment, since the suppression ratios $X_1$ [dB], $X_2$ [dB] of the low-pass filters 3a, 3b can be made sufficiently low with respect to the suppression ratios $X_3$ [dB] of the 3rd intermodulation component and not only the 3rd wave but also the fundamental wave is suppressed, the frequency-gain characteristic of the low-pass filters 3a, 3b can be set to a smoothly changing characteristic as shown in FIG. 4. Therefore, the low-pass filters 3a, 3b can be realized with an extremely simple construction in comparison with the low-pass filter having the frequency-gain characteristic as shown in FIG. 2.

(Fifth Embodiment)

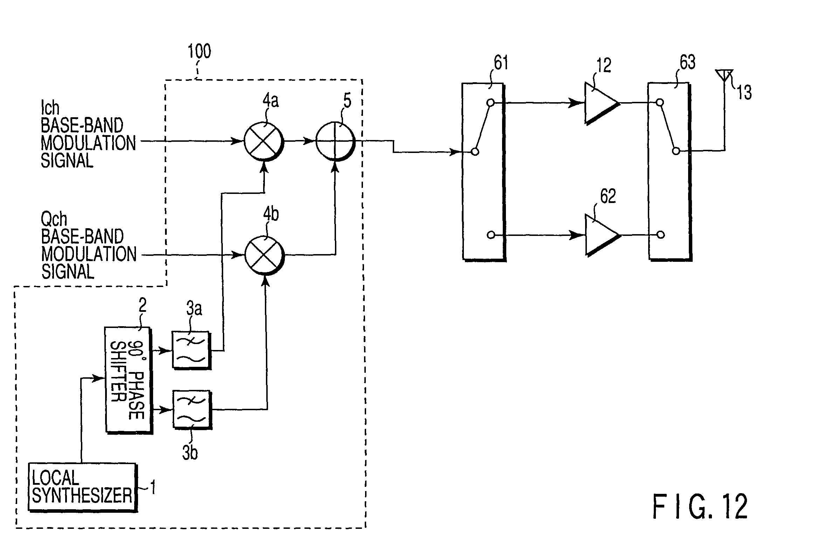

FIG. 11 is a block diagram showing the construction of a radio transmission apparatus constructed by using the quadrature modulation apparatus 100 shown in FIG. 3. Portions which are the same as those shown in FIG. 3 are denoted by the same reference numerals and a detailed explanation therefor is omitted.

As shown in FIG. 11, the radio transmission apparatus of this embodiment includes the quadrature modulation apparatus 100, main amplifier 12 and antenna 13.

That is, the radio transmission apparatus of this embodiment is constructed by eliminating the PLL of the radio transmission apparatus of the first embodiment and a modulation signal output from the quadrature modulation apparatus 100 is directly supplied to the main amplifier 12.

That is, the radio transmission apparatus transmits the modulation signal obtained in the quadrature modulation apparatus 100 as it is by radio according to a direct conversion system by use of radio transmission means realized by the main amplifier 12 without performing the frequency conversion.

With the above construction, since the main amplifier 12 is required to perform the non-linear operation like the non-linear amplifier 7 in the first embodiment, a 3rd intermodulation component is contained in the transmission signal which is an output of the main amplifier 12. However, the 3rd intermodulation component can be suppressed to a sufficiently low value by the same action as in the first embodiment and the 3rd wave is also sufficiently suppressed, and therefore, spurious signals transmitted by radio from the antenna 13 can be reduced.

Further, in this embodiment, since the suppression ratios $X_1$ [dB], $X_2$ [dB] of the low-pass filters 3a, 3b can be made sufficiently low with respect to the suppression ratios $X_3$ [dB] of the 3rd intermodulation component and not only the 3rd wave but also the fundamental wave is suppressed, the frequency-gain characteristic of the low-pass filters 3a, 3b can be set to a smoothly changing characteristic as shown in FIG. 4. Therefore, the low-pass filters 3a, 3b can be realized with an extremely simple construction in comparison with the low-pass filter having the frequency-gain characteristic as shown in FIG. 2.

(Sixth Embodiment)

FIG. 12 is a block diagram showing the construction of a radio transmission apparatus constructed by using the quadrature modulation apparatus 100 shown in FIG. 3. Portions which are the same as those shown in FIG. 3 are denoted by the same reference numerals and a detailed explanation therefor is omitted.

As shown in FIG. 12, the radio transmission apparatus of this embodiment includes the quadrature modulation apparatus 100, main amplifier 12, antenna 13, selector 61, main amplifier 62 and selector 63.

That is, the radio transmission apparatus of this embodiment includes the selector 61, main amplifier 62 and selector 63 in addition to the radio transmission apparatus of the fifth embodiment.

A modulation signal output from the quadrature modulation apparatus 100 is supplied to the selector 61. The selector 61 selectively supplies the modulation signal output from the quadrature modulation apparatus 100 to one of the main amplifiers 12 and 62. The main amplifier 62 amplifies the transmission signal supplied thereto via the selector 61 to a power level required for radio transmission and then supplies the amplified signal as a transmission signal. The selector 63 selects one of the main amplifiers 12 and 62 in an interlocked manner with the selector 61. The selector 63 supplies the transmission signal output from the selected main amplifier to the antenna 13.

That is, the radio transmission apparatus transmits the modulation signal obtained by the quadrature modulation apparatus 100 by radio according to a direct conversion system and permits either of the two different system communication frequency bands to be used.

With the above construction, since each of the main amplifiers 12, 62 is required to perform the non-linear operation like the non-linear amplifier 7 in the first embodiment, a 3rd intermodulation component is contained in the transmission signal which is an output of each of the main amplifiers 12, 62. However, the 3rd intermodulation component can be suppressed to a sufficiently small value by the same action as in the first embodiment and the 3rd wave is also sufficiently suppressed, and therefore, spurious signals transmitted by radio from the antenna 13 can be reduced.

Further, in this embodiment, since the suppression ratios $X_1$ [dB], $X_2$ [dB] of the low-pass filters 3a, 3b can be made sufficiently low with respect to the suppression ratios $X_3$ [dB] of the 3rd intermodulation component and not only the 3rd wave but also the fundamental wave is suppressed, the frequency-gain characteristic of the low-pass filters 3a, 3b can be set to a smoothly changing characteristic as shown in FIG. 4. Therefore, the low-pass filters 3a, 3b can be realized with an extremely simple construction in comparison with the low-pass filter having the frequency-gain characteristic as shown in FIG. 2.

(Seventh Embodiment)

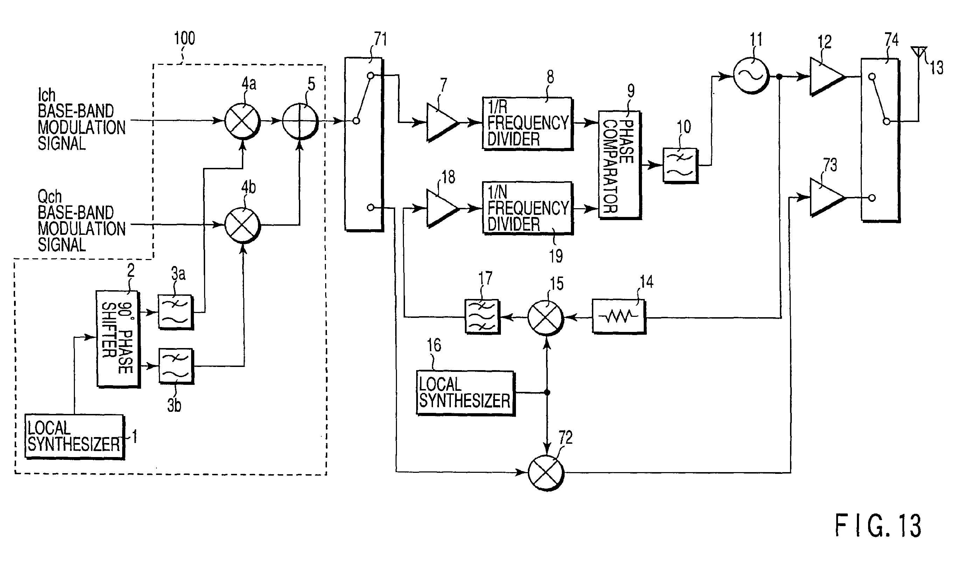

FIG. 13 is a block diagram showing the construction of a radio transmission apparatus constructed by using the quadrature modulation apparatus 100 shown in FIG. 3. Portions which are the same as those shown in FIGS. 3, 5 are denoted by the same reference numerals and a detailed explanation therefor is omitted.

As shown in FIG. 13, the radio transmission apparatus of this embodiment includes the quadrature modulation apparatus 100, non-linear amplifier 7, 1/R frequency divider 8, phase comparator 9, loop filter 10, voltage-controlled oscillator 11, main amplifier 12, antenna 13, attenuator 14, down-converting mixer 15, local synthesizer 16, band-pass filter 17, non-linear amplifier 18, 1/N frequency divider 19, selector 71 used as selection means, up-converter 72, main amplifier 73 and selector 74 used as selection means.

That is, the radio transmission apparatus of this embodiment includes the selector 71, up-converter 72, main amplifier 73 and selector 74 in addition to the radio transmission apparatus of the first embodiment.

A modulation signal output from the quadrature modulation apparatus 100 is supplied to the selector 71. The selector 71 selectively supplies the modulation signal output from the quadrature modulation apparatus 100 to one of the non-linear amplifier 7 and up-converter 72. The up-converter 72 is supplied with a local signal from the local synthesizer 16 in addition to the modulation signal supplied via the selector 71. The up-converter 72 generates a transmission signal obtained by multiplying the modulation signal by the local signal and up-converting the modulation signal to a frequency band corresponding to the frequency of the local signal. The local synthesizer 16 generates a local signal of a frequency which is different according to one of the non-linear amplifier 7 and up-converter 72 selected by the selector 71. The local synthesizer 16 generates a local signal having the central frequency of a predetermined system communication frequency band which is different from the system communication frequency band to which the central frequency of the transmission signal generated from the voltage-controlled oscillator 11 belongs.

The transmission signal output from the up-converter 72 is amplified by the main amplifier 73 to a power level required for radio transmission and supplied to the antenna 13 via the selector 74. The selector 74 selects one of the main amplifiers 12 and 73 in an interlocked manner with the selector 71. Then, the selector 74 supplies the transmission signal output from the selected main amplifier to the antenna 13.

That is, the radio transmission apparatus transmits the modulation signal obtained by the quadrature modulation apparatus 100 by radio by selectively using one of a modulation loop system and up-conversion system respectively corresponding to the different system communication frequency bands.

With the above construction, spurious signals transmitted by radio from the antenna 13 is reduced in the same manner as in the first embodiment when the modulation loop system is used. Further, since the up-converter 72 performs the non-linear operation like the non-linear amplifier 7 when the up-conversion system is used, a 3rd intermodulation component is contained in the transmission signal which is an output of the up-converter 72. However, the 3rd intermodulation component can be suppressed to a sufficiently small value by the same action as in the first embodiment and the 3rd wave is also sufficiently suppressed, and therefore, spurious signals transmitted by radio from the antenna 13 can be reduced.

Further, in this embodiment, since the suppression ratios $X_1$ [dB], $X_2$ [dB] of the low-pass filters 3a, 3b can be made sufficiently low with respect to the suppression ratios $X_3$ [dB] of the 3rd intermodulation component and not only the 3rd wave but also the fundamental wave is suppressed, the frequency-gain characteristic of the low-pass filters 3a, 3b can be set to a smoothly changing characteristic as shown in FIG. 4. Therefore, the low-pass filters 3a, 3b can be realized with an extremely simple construction in comparison with the low-pass filter having the frequency-gain characteristic as shown in FIG. 2.

(Eighth Embodiment)

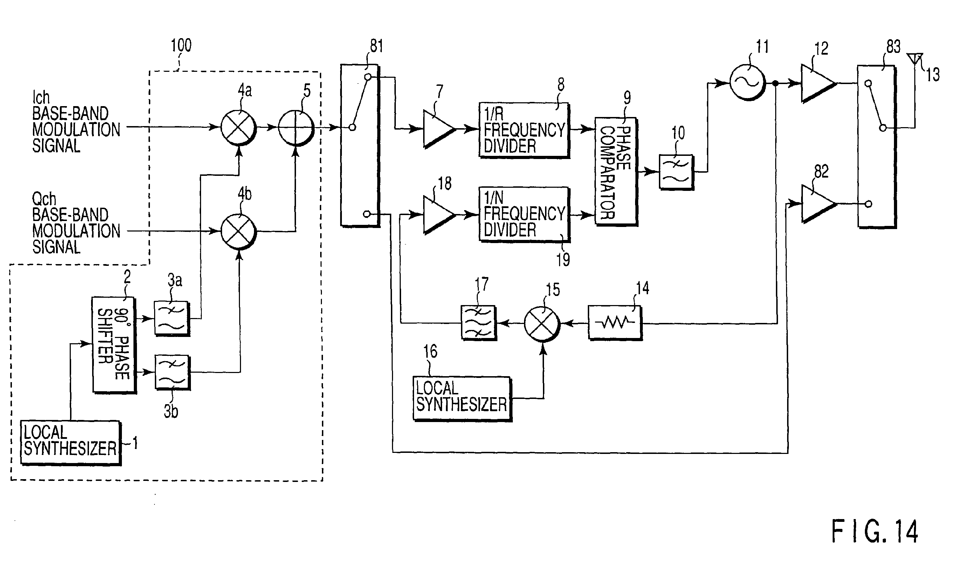

FIG. 14 is a block diagram showing the construction of a radio transmission apparatus constructed by using the quadrature modulation apparatus 100 shown in FIG. 3. Portions which are the same as those shown in FIGS. 3, 5 are denoted by the same reference numerals and a detailed explanation therefor is omitted.

As shown in FIG. 14, the radio transmission apparatus of this embodiment includes the quadrature modulation apparatus 100, non-linear amplifier 7, 1/R frequency divider 8, phase comparator 9, loop filter 10, voltage-controlled oscillator 11, main amplifier 12, antenna 13, attenuator 14, down-converting mixer 15, local synthesizer 16, band-pass filter 17, non-linear amplifier 18, 1/N frequency divider 19, selector 81 used as selection means, main amplifier 82 and selector 83 used as selection means.

That is, the radio transmission apparatus of this embodiment includes the selector 81, main amplifier 82 and selector 83 in addition to the radio transmission apparatus of the first embodiment.

A modulation signal output from the quadrature modulation apparatus 100 is supplied to the selector 81. The selector 81 selectively supplies the modulation signal output from the quadrature modulation apparatus 100 to one of the non-linear amplifier 7 and main amplifier 82. The main amplifier 82 amplifies a modulation signal supplied via the selector 81 to a power level required for radio transmission and outputs the amplified signal as a transmission signal. The selector 83 selects one of the main amplifiers 12 and 82 in an interlocked manner with the selector 81. Then, the selector 83 supplies the transmission signal output from the selected main amplifier to the antenna 13.

That is, the radio transmission apparatus transmits the modulation signal obtained by the quadrature modulation apparatus 100 by radio by selectively using one of a modulation loop system and direct conversion system respectively corresponding to different system communication frequency bands.

With the above construction, spurious signals transmitted by radio from the antenna 13 are reduced in the same manner as in the first embodiment when the modulation loop system is used. Further, since the main amplifier 82 performs the non-linear operation like the non-linear amplifier 7 when the direct conversion system is used, a 3rd intermodulation component is contained in the transmission signal which is an output of the main amplifier 82. However, the 3rd intermodulation component can be suppressed to a sufficiently low value by the same action as in the first embodiment and the 3rd wave is also sufficiently suppressed, and therefore, spurious signals transmitted by radio from the antenna 13 can be reduced.

Further, in this embodiment, since the suppression ratios $X_1$ [dB], $X_2$ [dB] of the low-pass filters 3a, 3b can be made sufficiently low with respect to the suppression ratios $X_3$ [dB] of the 3rd intermodulation component and not only the 3rd wave but also the fundamental wave is suppressed, the frequency-gain characteristic of the low-pass filters 3a, 3b can be set to a smoothly changing characteristic as shown in FIG. 4. Therefore, the low-pass filters 3a, 3b can be realized with an extremely simple construction in comparison with the low-pass filter having the frequency-gain characteristic as shown in FIG. 2.

(Ninth Embodiment)

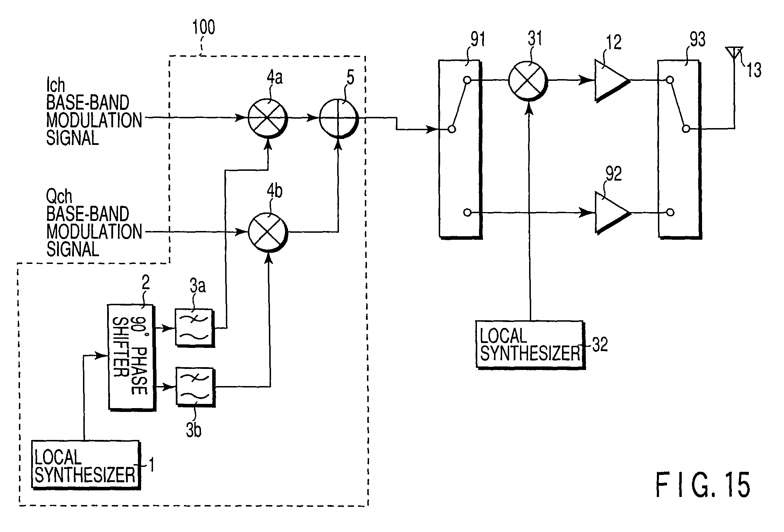

FIG. 15 is a block diagram showing the construction of a radio transmission apparatus constructed by using the quadrature modulation apparatus 100 shown in FIG. 3. Portions which are the same as those shown in FIGS. 3, 5, 9 are denoted by the same reference numerals and the detailed explanation therefor is omitted.

As shown in FIG. 15, the radio transmission apparatus of this embodiment includes the quadrature modulation apparatus 100, main amplifier 12, antenna 13, up-converter 31, local synthesizer 32, selector 91 used as selection means, main amplifier 92 and selector 93 used as selection means.

That is, the radio transmission apparatus of this embodiment includes the selector 91, main amplifier 92 and selector 93 in addition to the radio transmission apparatus of the third embodiment.

A modulation signal output from the quadrature modulation apparatus 100 is supplied to the selector 91. The selector 91 selectively supplies the modulation signal output from the quadrature modulation apparatus 100 to one of the up-converter 31 and main amplifier 92. The main amplifier 92 amplifies a modulation signal supplied via the selector 91 to a power level required for radio transmission and outputs the amplified signal as a transmission signal. The selector 93 selects one of the main amplifiers 12 and 92 in an interlocked manner with the selector 91. Then, the selector 93 supplies the transmission signal output from the selected main amplifier to the antenna 13.

That is, the radio transmission apparatus transmits the modulation signal obtained by the quadrature modulation apparatus 100 by radio by selectively using one of an up-conversion system and direct conversion system respectively corresponding to different system communication frequency bands.

With the above construction, spurious signals transmitted by radio from the antenna 13 are reduced in the same manner as in the third embodiment when the up-conversion system is used. Further, since the main amplifier 92 performs the non-linear operation like the non-linear amplifier 7 in the first embodiment when the direct conversion system is used, a 3rd intermodulation component is contained in the transmission signal which is an output of the main amplifier 92. However, the 3rd intermodulation component can be suppressed to a sufficiently low value by the same action as in the first embodiment and the 3rd wave is also sufficiently suppressed, and therefore, spurious signals transmitted by radio from the antenna 13 can be reduced.

As described above, according to the quadrature modulation apparatus 100 of this embodiment, if a circuit performing the non-linear operation is connected to the succeeding stage thereof, the 3rd intermodulation component and 3rd wave of an output of the circuit can be sufficiently suppressed to a small value and it is possible to reduce spurious signals by applying the quadrature modulation apparatus to various types of radio transmission apparatuses as described in the above embodiments.

Further, in this embodiment, since the suppression ratios $X_1$ [dB], $X_2$ [dB] of the low-pass filters 3a, 3b can be made sufficiently low with respect to the suppression ratios $X_3$ [dB] of the 3rd intermodulation component and not only the 3rd wave but also the fundamental wave is suppressed, the frequency-gain characteristic of the low-pass filters 3a, 3b can be set to a smoothly changing characteristic as shown in FIG. 4. Therefore, the low-pass filters 3a, 3b can be realized with an extremely simple construction in comparison with the low-pass filter having the frequency-gain characteristic as shown in FIG. 2.

This invention is not limited to the embodiments described above. For example, in each of the above embodiments, the local synthesizer 1 is contained in the quadrature modulation apparatus, but the quadrature modulation apparatus can be designed so as not to contain the local synthesizer 1 and can be supplied with a local signal from the exterior.

Further, all of the local synthesizer 1, 90° phase shifter 2, low-pass filters 3a, 3b, multipliers 4a, 4b and adder 5 in each of the above embodiments can be realized by use of a hardware circuit or part or all of them can be realized by use of a digital signal processing circuit.

In addition, this invention can be modified without departing from the technical scope thereof.

**Claims**

1.  A quadrature modulation apparatus comprising:

    local signal generating means (2) for generating two local signals each having a fundamental wave of a predetermined frequency and having a 90° phase difference therebetween;
    two low-pass filters (3a, 3b) for suppressing high-frequency band components of the two local signals generated from said local signal generating means (2), each of the high-frequency band components containing the fundamental wave; and
    modulation means (4a, 4b, 5) for subjecting two-channel base band signals to quadrature modulation by use of the two local signals respectively output from said two low-pass filters (3a, 3b).

2.  A radio transmission apparatus comprising:

    local signal generating means (2) for generating two local signals each having a fundamental wave of a predetermined frequency and having a 90° phase difference therebetween;
    two low-pass filters (3a, 3b) for suppressing high-frequency band components of the two local signals generated from said local signal generating means (2), each of the high-frequency band components containing the fundamental wave;
    modulation means (4a, 4b, 5) for subjecting two-channel base band signals to quadrature modulation by use of the two local signals respectively output from said two low-pass filters (3a, 3b); and
    radio transmission means for radio-transmitting a modulation signal obtained by said modulation means.

3.  The radio transmission apparatus according to claim 2, **characterized in that** said radio transmission means is of a modulation loop system which includes a non-linear amplifier (7) for amplifying the modulation signal, generates a transmission signal having the same phase deviation as a modulation signal obtained after amplification by the non-linear amplifier (7) and transmits the transmission signal by radio.

4.  The radio transmission apparatus according to claim 3, **characterized in that** said radio transmission means selectively sets a frequency band of the transmission signal to one of a plurality of predetermined frequency bands.

5.  The radio transmission apparatus according to claim 2, **characterized in that** said radio transmission means is of an up-conversion system which includes an up-converter (31) for generating a transmission signal whose frequency band is converted to a predetermined frequency band by synthesizing the modulation signal with a predetermined local signal and transmits the transmission signal obtained by said up-converter (31) by radio.

6.  The radio transmission apparatus according to claim 5, **characterized in that** said radio transmission means selectively sets a frequency band of the transmission signal to one of a plurality of predetermined frequency bands.

7.  The radio transmission apparatus according to claim 2, **characterized in that** said radio transmission means is of a direct conversion system for radio-transmitting the modulation signal as it is as a transmission signal.

8.  The radio transmission apparatus according to claim 7, **characterized in that** said radio transmission means selectively sets a frequency band of the transmission signal to one of a plurality of predetermined frequency bands.

9.  The radio transmission apparatus according to claim 2, **characterized in that** said radio transmission means includes first transmission means of a modulation loop system which includes a non-linear amplifier (7) for amplifying the modulation signal, generates a transmission signal having the same phase deviation as a modulation signal obtained after amplification by the non-linear amplifier (7) and transmits the transmission signal by radio; second transmission means of an up-conversion system which includes an up-converter (72) for generating a transmission signal whose frequency band is converted to a predetermined frequency band by synthesizing the modulation signal with a predetermined local signal and transmits the transmission signal obtained by said frequency converting means by radio; and selection means (71, 74) for selectively operating one of said first and second transmission means.

10. The radio transmission apparatus according to claim 2, **characterized in that** said radio transmission means includes first transmission means of a modulation loop system which includes a non-linear amplifier (7) for amplifying the modulation signal, generates a transmission signal having the same phase deviation as a modulation signal obtained after amplification by the non-linear amplifier (7) and transmits the transmission signal by radio; second transmission means of a direct conversion system for radio-transmitting the modulation signal as it is as a transmission signal; and selection means (81, 83) for selectively operating one of said first and second transmission means.

11. The radio transmission apparatus according to claim 2, **characterized in that** said radio transmission means includes first transmission means of an up-conversion system which includes an up-converter (31) for generating a transmission signal whose frequency band is converted to a predetermined frequency band by synthesizing the modulation signal with a predetermined local signal and transmits the transmission signal obtained by said frequency converting means by radio; second transmission means of a direct conversion system for radio-transmitting the modulation signal as it is as a transmission signal; and selection means (91, 93) for selectively operating one of said first and second transmission means.

12. A quadrature modulation apparatus comprising:

    local signal generator (2) which generates two local signals each having a fundamental wave of a predetermined frequency and having a 90° phase difference therebetween;
    two low-pass filters (3a, 3b) which suppresses high-frequency band components of the two local signals generated from said local signal generator (2), each of the high-frequency band components containing the fundamental wave; and
    modulator (4a, 4b, 5) which inputs the two local signals respectively outputs from said two low-pass filters (3a, 3b) and which outputs two-channel quadrature modulated base-band signals.

13. A radio transmission apparatus comprising:

    local signal generator (2) which generates two local signals each having a fundamental wave of a predetermined frequency and having a 90° phase difference therebetween;
    two low-pass filters (3a, 3b) which suppresses high-frequency band components of the two local signals generated (2) from said local signal generator, each of the high-frequency band components containing the fundamental wave;
    modulator (4a, 4b, 5) which inputs the two local signals respectively outputs from said two low-pass filters (3a, 3b) which outputs two-channel quadrature modulated base-band signals; and
    transmitter which transmits the modulated signal.

14. The radio transmission apparatus according to claim 13, **characterized in that** said transmitter is of a modulation loop which includes a non-linear amplifier (7) which amplifies the modulation signal, generates a transmission signal having the same phase deviation as a modulation signal obtained after amplification by the non-linear amplifier and transmits the transmission signal.

15. The radio transmission apparatus according to claim 14, **characterized in that** said transmitter selectively sets a frequency band of the transmission signal to one of a plurality of predetermined frequency bands.

16. The radio transmission apparatus according to claim 13, **characterized in that** said transmitter is of an up-conversion system which includes an up-converter (31) which generates a transmission signal whose frequency band is converted to a predetermined frequency band by synthesizing the modulation signal with a predetermined local signal and transmits the transmission signal obtained by said up-converter (31).

17. The radio transmission apparatus according to claim 16, **characterized in that** said transmitter which selectively sets a frequency band of the transmission signal to one of a plurality of predetermined frequency bands.

18. The radio transmission apparatus according to claim 13, **characterized in that** said transmitter is of a direct conversion system for radio-transmitting the modulation signal as it is as a transmission signal.

19. The radio transmission apparatus according to claim 18, **characterized in that** said transmitter which selectively sets a frequency band of the transmission signal to one of a plurality of predetermined frequency bands.

20. The radio transmission apparatus according to claim 13, **characterized in that** said transmitter which includes first transmitter of a modulation loop system which includes a non-linear amplifier (7) which amplifies the modulation signal, generates a transmission signal having the same phase deviation as a modulation signal obtained after amplification by the non-linear amplifier (7) and transmits the transmission signal; second transmitter of an up-conversion system which includes an up-converter (72) which generates a transmission signal whose frequency band is converted to a predetermined frequency band by synthesizing the modulation signal with a predetermined local signal and transmits the transmission signal obtained by said frequency converter; and selector (71, 74) which selects one of said first and second transmitter.

21. The radio transmission apparatus according to claim 13, **characterized in that** said transmitter includes first transmitter of a modulation loop system which includes a non-linear amplifier (7) which amplifies the modulation signal, generates a transmission signal having the same phase deviation as a modulation signal obtained after amplification by the non-linear amplifier (7) and transmits the transmission signal; second transmitter of a direct conversion system which transmits the modulation signal as it is as a transmission signal; and selector (81, 83) which selects one of said first and second transmitter.

22. The radio transmission apparatus according to claim 13, **characterized in that** said transmitter includes first transmitter of an up-conversion (31) system which includes an up-converter which generates a transmission signal whose frequency band is converted to a predetermined frequency band by synthesizing the modulation signal with a predetermined local signal and transmits the transmission signal obtained by said frequency converter; second transmitter of a direct conversion system which transmits the modulation signal as it is as a transmission signal; and selector (91, 93) which selects one of said first and second transmitter.

23. A quadrature modulation method comprising the steps of:

generating two local signals each having a fundamental wave of a predetermined frequency and having a 90° phase difference therebetween;
suppressing high-frequency band components of the two local signals, each of the high-frequency band components containing the fundamental wave; and
subjecting two-channel base-band signals to quadrature modulation by use of with the two local signals whose high-frequency band components are suppressed.

24. A quadrature modulation method comprising the steps of:

generating two local signals each having a fundamental wave of a predetermined frequency and having a 90° phase difference therebetween;
suppressing high-frequency band components of the two local signals, each of the high-frequency band components containing the fundamental wave; and
quadrature modulating two-channel base-band signals with the two local signals whose high-frequency band components are suppressed.

FIG. 1A

FIG. 1B

FIG. 1C

14

FIG.2

GAIN

X

FUNDAMENTAL
WAVE

3RD
WAVE

FREQUENCY

Ich
BASE-BAND
MODULATION
SIGNAL

4a

5

MODULATION
SIGNAL

Qch
BASE-BAND
MODULATION
SIGNAL

4b

3a

2

90° PHASE
SHIFTER

3b

LOCAL
SYNTHESIZER

1

FIG.3

GAIN

X1
X2

F I G. 4

FUNDAMENTAL
WAVE
FREQUENCY

3RD HARMONICS
WAVE

3RD WAVE OF OUTPUT FROM QUADRATURE
MODULATOR [dBm]

FOR 3RD
HARMONICS
WAVE

FOR
FUNDAMENTAL
WAVE

TARGET
VALUE

F I G. 7

FUNDAMENTAL WAVE AND 3RD HARMONICS WAVE OF
LOCAL SIGNAL INPUT TO QUADRATURE MODULATOR [dBm]

FIG. 5

FIG. 6A

FUNDAMENTAL
WAVE

3RD
HARMONICS
WAVE

fif    3fif

FIG. 6B

$x_1$

FUNDAMENTAL
WAVE

$x_2$

3RD
HARMONICS
WAVE

fif    3fif

FIG. 6C

FUNDAMENTAL
WAVE

$f_{BB}$

$f_{BB}$

$x_3$

3RD
WAVE

fif    3fif

FIG. 6D

FUNDAMENTAL
WAVE

$f_{BB}$

$x_3$

3RD
INTERMODULATION
COMPONENT

$3f_{BB}$

3RD
WAVE

$f_{BB}$

fif    3fif

FIG. 8

F I G. 9

F I G. 11

F I G. 10

Ich BASE-BAND MODULATION SIGNAL

Qch BASE-BAND MODULATION SIGNAL

90° PHASE SHIFTER

LOCAL SYNTHESIZER

LOCAL SYNTHESIZER

EP 1 217 723 A2

F I G. 12

FIG. 13

FIG. 14

FIG. 15